# EUROPEAN PATENT APPLICATION

(11) **EP 1 650 870 A2**
(43) Date of publication of application: **26.04.2006**
(21) Application number: 05380162.7
(22) Date of filing: 20.07.2005
(51) Int. Cl.: H03K 17/18, H03K 17/08

(54) **Device, system and installation to control electrical power supplied to a load**

(30) Priority: 22.10.2004 ES 200402525
(71) Applicant: Domoblue, S.L., 46980 Paterna (Valencia) (ES)
(72) Inventor: Cabezas Bueno, Carlos, 46980 Paterna Valencia (ES); Rodriguez Parilla, Javier, 46980 Paterna Valencia (ES)
(74) Representative: Carpintero Lopez, Francisco

(57) **Abstract**

Device to control the power supplied to a load, that consists of:
a group of electrical terminals (1-3);
a first power control element (6) connected in series between two of the terminals (1, 3);
a switching element (5) located in series between two of the terminals (2, 3); and
an event detector (4) connected to one of the terminals (2) to detect an event in a line connected to this terminal and to produce an output signal indicating the event when it detects it.

The device allows the control of the load both via the first power control element (6) and via an external switch 400 jumpered by the device.

## Description

### TECHNICAL FIELD OF THE INVENTION

The invention refers to a device, system and installation that facilitates the remote control of the power supplied to a load (for example, to switch a lamp or similar on or off, or to carry the power supplied to the load, for example, to be able to adjust the level of lighting provided by a lamp).

### BACKGROUND TO THE INVENTION

There are more or less complex systems for regulating the power supplied to a load, for example, switches or regulators fitted into the current/power supply line (that is, in the cable through which the current passes) and that allow the power supplied to be varied, for example, opening or closing the switch, changing the value of a variable resistor, etc. As an example, there are light switches that are used to switch lamps on and off, in homes, for example.

Taking advantage of progress in computer and telecommunications technologies, new technologies are being developed to control homes, etc, remotely and/or using computers. These home automation systems include the control of parameters relating to homes, work places, etc, using computer systems that operate devices in the premises, switching the lights on and off, controlling the temperature and air conditioning, monitoring electrical consumption, etc. These systems are often combined with security systems to generate alarms under certain conditions such as fire, flood, intrusion, etc.

So that computers can control the elements under supervision, for example, the status of lamps in a home, they must act as a switch. Since it is impractical to install devices that allow a computer to operate a conventional switch, such as that of a lamp, physically, switches that are specifically designed to interface with a computer are usually installed. That is, switches are installed in the appropriate points of the electrical lines in the home that receive instructions (by cable or wireless) from a remote control or local or central unit in the computer controlling the home. United States patent application **US-A-2003/0016129** describes a switch of this type.

These switches can replace conventional switches or be jumpered across them so that the two co-exist in the same place. However, jumpering the conventional switch can cause problems since when the user operates it without knowing that it is jumpered, he may be annoyed to find that the action produces no effect (for example, when operating the jumpered conventional switch for a lamp, the lamp's state does not change since the state - on/off - is controlled by the new home automation switch). That is, the co-existence of the two switches (the conventional one and the home automation one) may cause annoyance when the user tries to switch on the lamp with the conventional switch without seeing any change in the state (on/off) of the light.

This inconvenience is avoided if the conventional switch is replaced with the home automation switch, which is the usual situation. In new homes and premises, often only the home automation switches are installed. However, this can give rise to another problem, since the home automation switch may develop faults, due to its greater complexity, that require the attention of a specialist. The specialist may delay in arriving and the user may find himself unable to control the power for certain loads (for example, unable to switch a specific lamp on or off) for a period (often a long one).

### DESCRIPTION OF THE INVENTION

An initial aspect of the invention refers to a device to control the electrical power or current supplied to a load (for example, to a lamp, a radiator, etc) connected to a power source (for example, to the electrical cables in a home). The device consists of:
a group of electrical terminals (three, for example) configured to connect the device in the load's electrical supply line (in series with the load);
a first power control device (for example, a switch that can change between the open and closed states, or a control element that can also regulate the power to the load to values between the open and closed or on/off states, for example, based on a variable resistor or on power control semiconductor components) connected between two of the terminals, so that the first power control element can control the electrical power supplied to the load via the control device, in a first operating mode of the control device in which electrical power is supplied (exclusively or almost exclusively) via and under the control of the first power control element.

The device in the invention also contains a switching element between two of the terminals and configured to place the control device selectively in the first operating mode and in a second operating mode in which the power does not pass through the first power control element (this can be achieved, for example, by setting the first power control element in its open state so that it does not allow current to pass, while setting the switching element to a state that allows the power/current to flow to the load without passing through the first power control element). Thus, the switching element can be used to choose between two operating modes, one in which the first power control element sets the power supply level and another (the second operating mode) in which the first power control element is isolated from the power flow because it has been jumpered by the switching element (this may require the first power control element to be set to its open state to allow all the current to pass through the other route). In this second operating mode, an external switch (for example, a conventional switch) connected in series with a terminal on the device in the invention, could take full control over the supply of power to the load, without the power supplied being affected by the state of the first power control element.

The device in the invention also includes an event detector connected to one of the terminals and configured to detect an event in a line connected to this terminal (for example, to detect current in the line) and to produce an output signal indicating an event when it occurs. For example, the event detector could be configured to detect a current or voltage change in the terminal to which it is connected to react to the event by sending the relevant output signal.

This output signal indicating the event could co-ordinate the device with incidents relating to the line connected to terminal in question. For example, if the line is connected to an external switch (for example, a conventional switch that co-exists with the device in the invention in the load's electrical system) current could flow in the line and this will be detected by the event detector (which could be configured as a current detector), thus producing the output signal indicating the event.

This signal could be processed by the device or by a mechanism external to it and produce a specific event, for example, a change of state in the first power control element.

Thus, if a user operates the external switch (which could be the conventional switch described above), this could cause an automatic change (induced by the event detector's output signal) in the state of the first power control element. That is, to change the power supply (for example, to switch a lamp on or off), the user need not directly operate the first power control element or on its home automation system, but only needs to operate the external switch. Regardless of the original position of the external switch (something that is irrelevant in principle since the power supply is controlled by the first power control element), the event (for example, the appearance of current) caused in the line connected to the event detector by operating the external switch, is taken as an indication that the user wishes to change the supply state so that the first power control element is operated automatically, changing its state (from open to closed or closed to open). Thus, the device is transparent to the user, that is, the user can operate the external switch and achieve the relevant affect on the load as though the device in the invention was not fitted in the electrical line.

As mentioned above, the event detected could be a current in the line when the line's switch is opened or closed. For this, the event detector connected to the relevant terminal could include a resistor connected to the terminal and a circuit connected to the resistor and be configured to generate the event signal when it detects current via the resistor. The resistor simulates a load that produces a small current when the switch in the line connected to the terminal is opened or closed. The circuit connected to the resistor and that produces the event signal could include an optical relay with at least one photo-electric diode connected to the resistor and which produces a light when current flows through the diode, which is received by another photo-electric diode that converts it into a small electrical current that activates a relay which, when closed, sends an electrical signal to the event detector's output to indicate the event.

The terminals could include a first terminal, a second terminal and a third terminal, with the switching element connected between the second and third terminals (so that an electrical current can pass between the second and third terminals when the device is in the second operating mode but not when the device is in the first operating mode), and with the first power control element connected between the first and third terminals (so that an electrical current can pass between the first and third terminals via and under the control of the first power control element). In this case, one pole of the load could be connected to the third terminal, and a power source could be connected directly to the first terminal and, for example, via an external switch, to the second terminal. With this configuration, and with the event detector also connected to the second terminal, the function described above is achieved.

The device could also include a current detector associated with one of the terminals (for example, to the third terminal), configured to generate a signal indicating the current level in this terminal. Monitoring the current flowing to the load allows problems in it to be detected (for example, a short circuit), in which case the load's power supply can be cut off.

Current detection also allows failure analysis to be carried out. For example, if the load (a light bulb) has blown, monitoring the current means that, even if the device is in a state that should allow current to flow to the load, an absence of current can be detected, meaning that the bulb has blown. The device can be configured so that it sends a signal in this circumstance (for example, audible) indicating that the load is (or could be) blown.

Current monitoring could form part of a more general control over the home automation system of which the device in the invention could form part.

The device can also include a voltage detector associated with one of the terminals (for example, to the first terminal, the line connecting the device with the power source) and configured to generate a signal indicating the voltage level in this terminal. This voltage detector could form part of a protection module configured to operate the first power control element to cut the supply if a condition indicating an important anomaly is detected (for example, it could be configured to cut off the supply if the voltage is above or below pre-set thresholds).

The voltage detector could also detect a lack of power, that is, a voltage cut, for example, because the circuit breaker for the load has tripped (for example, due to a short circuit in the system). Another function of the voltage detector could be to reset the system after a short circuit. For example, the device could be configured so that if there is a short circuit associated with the load, the first power control element stops conducting power and the switching element changes state, allowing current to flow through it to the load without passing through the first power control element, that is, leaving the relevant part of the device isolated. The circuit breaker is tripped by a short circuit, and when it is reset, if the short circuit remains, the circuit beaker will trip automatically and very quickly. The circuit breaker reset can be detected by measuring the voltage and if this persists for more than a set time (for example, more than 3 or 5 seconds), this can be taken to mean that the short circuit has been repaired. An electronic control unit in the device can then change the state of the switching element so that control of the supply of power to the load is returned to the first power control element.

As described above, the voltage detector and the first power control element can be linked so that a specific variation in the voltage causes the first power control element to switch to the open state and stops power from reaching the load.

The device may also include a communications module to communicate with a remote control unit, with the first power control element, the switching element and the event detector connected to the communications module so that the state of the first power control element and of the switching element can be controlled from the remote control unit, via the communications module. Among other things, this allows the device's data processing capacity to be reduced and moved to one or more external units (for example, one in each space to be supervised). Thus, the device can be configured so that it just passes information on the state of its components (including the event detector) to the remote control unit, which then interprets this information and sends the necessary instructions or signals to the device so that it can operate the elements, for example, to change the state of the first power control element in response to a change (current, etc) detected by the event detector.

The current and voltage detectors can also be connected to the communications module so that the remote control unit can receive all the data needed to decide how to change the state of the device's components and for other functions in the unit (for example, collecting power supply statistics to measure the time for which a lamp has been on).

The communications module could communicate by wireless with the remote control unit, for example, by radio (for example, by Bluetooth), infrared, etc.

Alternatively or additionally, the device could include its own control module, for example, in the form of an electronic control unit configured to receive information on the state of the elements in the device and to produce specific actions in response to conditions detected without the need to interact with a remote control unit. Thus, according to the invention, the devices could operate independently, for example, by reacting to stimuli (for example, to the event signal from the event detector) without needing to communicate with an external/remote control unit. For this, the switching element, the first power control element, the event detector (and, optionally, the current and voltage detectors too) could be connected to the electronic control unit, which could consist of a suitably-programmed micro-controller or similar. The programming of the micro-controller or similar and the choice of suitable components for the device (to form the first power control element, the switching element, the event detector, etc) are simple tasks for the average expert in the field and do not require a more detailed explanation.

Another aspect of the invention refers to a loads control system (for example, a computerised home control system) that includes a device as described above and an electronic control unit, with the electronic control unit configured so that it can change the state of the first power control element between open, in which it allows power to pass, and closed, in which power is not allowed to pass. The electronic control unit is configured so that when it receives an event signal from the event detector, it changes the state of the first power control element so that if it is in the open state it switches to closed and vice versa. The electronic control unit could be connected to the remote control unit or form part of the device itself, that is, as an internal control module in the device, for example, in the form of a micro-controller.

Another aspect of the invention refers to an installation that includes a device according to the invention and a second power control element (for example, a switch external to the device) connected in a power line connected to the terminal to which the event detector is connected (for example, so that the external switch is connected in parallel on two of the device's terminals, for example, on the first and second terminals). This configuration allows the supply of power to the load to be controlled vie the device (which could form part of a home automation system that controls the loads) while the device could respond to an action by the user on the external switch, as described above. It would also be possible to jumper the first power control element via the switching element, so that the power supply is controlled by the second power control element.

### DESCRIPTION OF DRAWINGS

To complement this description and to aid the better understanding of the properties of the invention and as a practical example of its application, a set of drawings is attached as illustrations - although not as limitations to it - as follows:
Figure 1 is a schematic of a lamp to which the power supply (current) is controlled by a conventional switch, according to the state of the art.
Figure 2 is a schematic of the device showing the preferred application of the invention fitted in an installation such as that in Figure 1.
Figures 3 and 4 are schematics of some modules forming part of a device according to the preferred application of the invention.
Figure 5 is a schematic of part of the event detector, according to the preferred application of the invention.
Figure 6 shows an alternative application to that shown in Figure 5.

### PREFERRED EMBODIMENT OF THE INVENTION

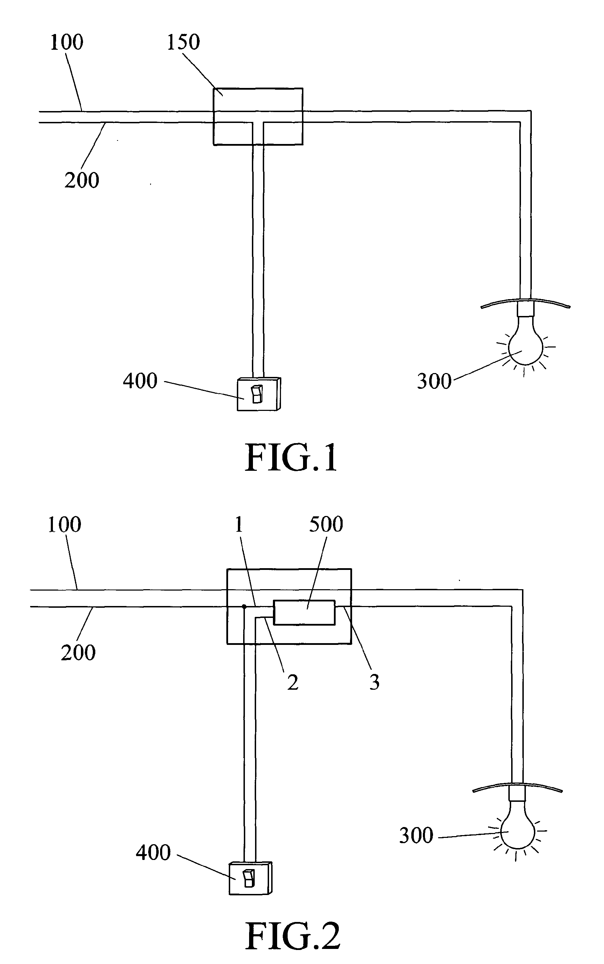

Figure 1 shows how, in the state of the art, lamp 300 receives its electrical power via two cables, 100 and 200, with the lamp connected between them. It also shows a connection box and connections, 150, in which switch 400 is installed in the supply line, specifically in cable 200. Thus, the switch can be used to control the power supply/current to the lamp 300, for example, if it is a two-position switch, cutting off the supply when the switch is in its open state or allowing the supply to pass when it is in its closed state.

Figure 2 shows how device 500 according to the preferred application of the invention has been installed in the power supply line, specifically in the cable 200, jumpering the switch 400. The device has three terminals, specifically, a first terminal 1 connected to the cable 200 between the power supply side and the switch 400, a second terminal 2 connected to another terminal on switch 400 (so that the switch is connected between the first second terminals, 1 and 2) and a third terminal, 3, connected via part of cable 200, to a terminal on the lamp, which has its other terminal connected to the cable 100.

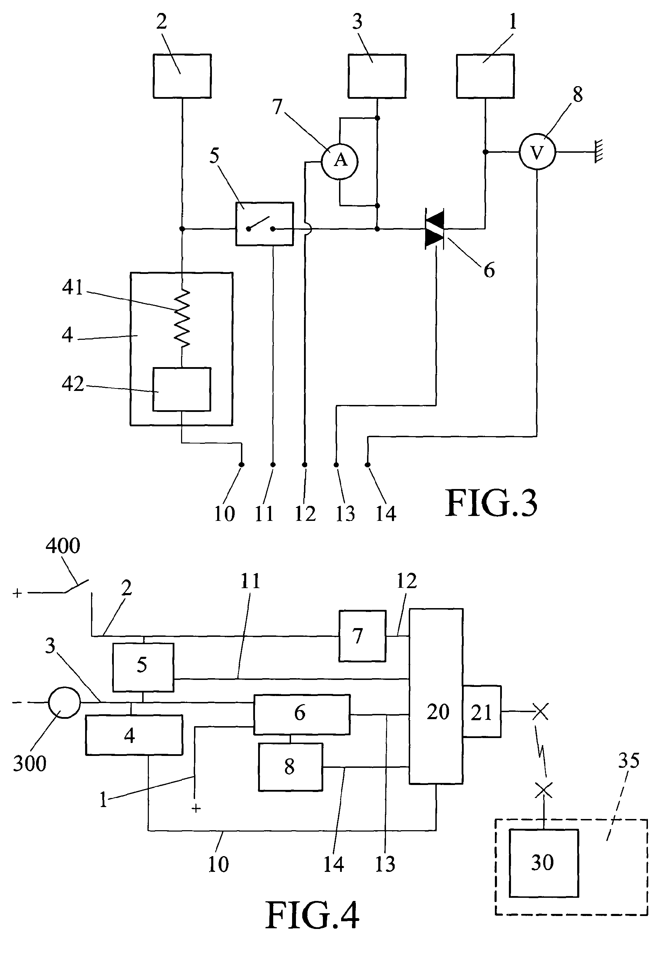

Figure 3 is a schematic of part of the device's internal structure, 500. Specifically, it shows how the first power control element, 6 (for example, a switch with two states, open and closed, and which could be, for example, an IGBT of the ST Microelectronics module STGP12NB60K, which can carry a voltage of up to 600 V and current of up to 15 A) is connected between the first terminal, 1, and the third terminal, 3, so that more or less power can pass between a power supply connected to the first terminal 1 and a load, 300 (not shown in Figure 3), connected to the third terminal, 3, depending on the state of the first power control element, 6. For example, with the first power control element in its open or off state, the power supply from the power source to the load is cut off.

It also shows how the switching element, 5 (which may also be a switch or relay with two states, open and closed, for example, a polarised relay with a normally open contact, for example, the DE series made by NAIS) is connected between the second terminal 2 and the third terminal 3. Depending on the state of the switching element (open or closed), power can or cannot pass between the second and third terminals, that is, between a power source connected to the second terminal and a load connected to the third terminal. Thus, through the switching element 3, power can flow from the second to the third terminal. Thus, and with the first power control element in its open state (off), the power supply to the load must flow via the second terminal 2, the switching element 5 and the third terminal 3. Thus, controlling the states of switching element 5 and of the first power control element 6, one can determine whether the power supply flows via the first power control element (in which case, as shown in figures 2 and 3, the state of the external switch 400 is irrelevant) or via the second terminal 2 and the third terminal 3 (on the switching element 5 in its closed state), in which case the power supply can be controlled with the external switch 400.

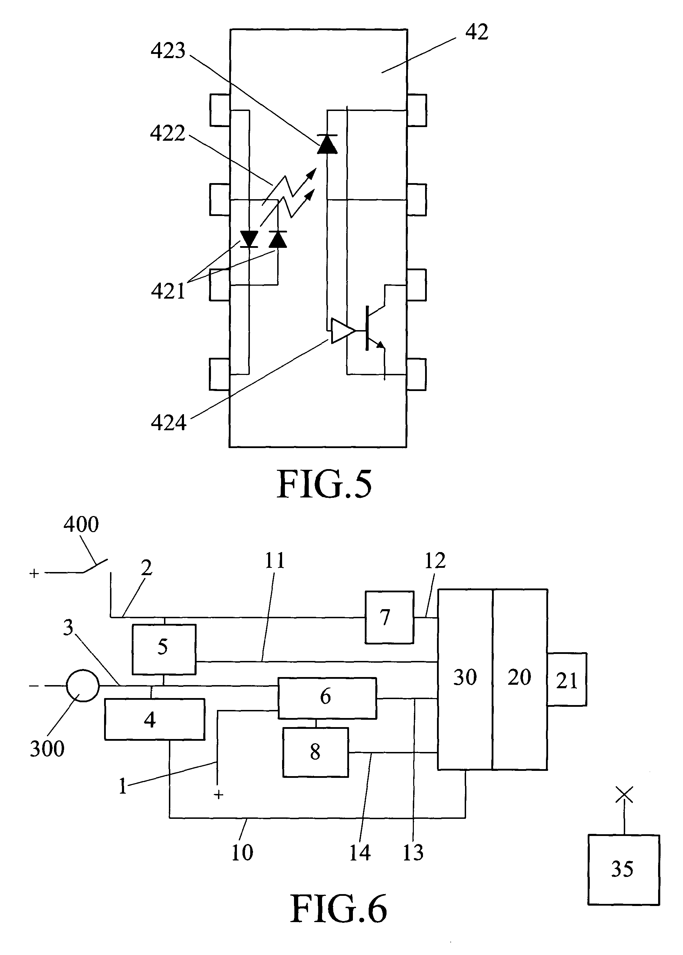

Figure 3 also shows the event detector 4 connected to the second terminal 2, which consists of the resistor 41 (which can be a conventional resistor of 22,000 Ohms) and a circuit 42 that can detect a current flowing through the resistor 41 and produce the appropriate event signal. When the state of an external switch connected to line 2 changes, a small current is produced in the load represented by the resistor 41. This current flows through the circuit 42 which could be an optical relay as shown in Figure 5 (and which could be, for example, the MID400 circuit sold by Fairchild Semiconductor Inc). The current in the resistor 41 produces a current in the LEDs 421, which cause a light signal, 423, which converts it into a small electrical current that activates the relay 424 which, when it closes, allows the event signal to pass. Thus, if anyone operates switch 400 in this configuration, a current is produced in the line connected to the second terminal 2, and this can be interpreted as an event indicating that the user wishes to change the supply of power to the load (for example, to switch off a lamp that is on or to switch on a lamp that is off), so that the electronic control unit 30 associated with device (shown in figures 4 and 6) can operate the first power control element changing its state (from open to closed or closed to open).

Figure 3 also shows the current detector 7 connected to the third terminal 3, and that produces a signal indicating the current level in this terminal, something which can be useful to detect problems in the load (for example, a short circuit) in which case the power to the load can be cut, or to allow the home automation system to obtain data on, for example, the consumption of a specific load, the time for which it is active, etc (also see the above description for the current detector).

Figure 3 also shows hoe the device includes a voltage detector 8 associated with the first terminal 1, that is, to the line connecting the device to the power source. The voltage detector 8 is configured to generate a signal indicating the voltage level in this terminal. This voltage detector could form part of a protection module configured to operate the first power control element to cut the supply if an important anomalous condition is detected (for example, it could be configured to cut off the supply if the voltage is above or below pre-set thresholds), as explained above.

Figure 3 also shows how the first power control element 6 is connected to a first communications terminal 13, via which the first power control element 6 can receive signals or instructions that cause a change in its state from the electronic control unit 30 (see Figures 4 and 6). The first power control element 6 varies the power/current according to the signals from the electronic control unit 30. Similarly, the switching element 5 is connected to a second communications terminal 11, the event detector 4 is connected to a third communications terminal 10, the current detector 6 is connected to a fourth communications terminal 12 and the voltage detector is connected to a fifth communications terminal 14. Figure 4 shows the modules in the device, in which the elements are the same as in Figure 3 (and therefore have the same reference numbers), and shows how the communication terminals 10-14 are connected to a communications module 20 with wireless communication 21 with an electronic control unit 30 associated with a remote control unit 35. This electronic control unit 30 receives information on the elements in the device via the communication terminals 10-14 and via the communications module 20, and can control the state of the first power control element 6 and of the switching element 5, sending instructions by wireless means via the communications module 20. Thus, the electronic control unit 30 can receive information from the event detector 4 on the operation of the external switch 400 and, in response to this information, send an instruction or signal to the device that causes a change in the state of the first power control element 6. Likewise, the electronic control unit 30 can decide to open both the switching element 5 and the first power control element 6 if it detects an over current in the third terminal 3 (detected by the current detector 7) or in response to a specific incident in the voltage measured by the voltage detector 8. Likewise, if the electronic control unit 30 detects an error condition in the device, it could choose to open the first power control element 6 and close the switching element 5, connecting terminals 2 and 3 so that the power control supplied operates directly and only via the external switch 400.

As an alternative to that shown in Figure 4, the electronic control unit 30 can be located in the device itself, 500, so that it is connected (directly) to the communication terminals 10-14, as shown in Figure 6. In this case, the electronic control unit 30 can be based on a micro-controller and be associated with communications module 20 with its wireless communication 21 so that the electronic control unit 30 can handle the device independently but can also receive instructions from a remote control unit 35 (for example, from a remote control or a transmitter/receiver for a home automation installation) and send information on the state of the components and/or incidents to the remote control unit 35.

From the above it can be seen that the device in the invention is ideal for home automation installations in which the switches (or other control elements) in the home automation system must live alongside switches (or other control elements) that are operated manually by the users.

## Claims

1. Device to control electrical power supplied to a load connected to a power source, **characterized in that** the device comprises:
a plurality of electrical terminals (1, 2, 3) configured for the connection of the device inserted in a line supplying power to the load;
a first power control element (6) connected between two of said terminals (1, 3), so that the first power control element (6) can control the electrical power supplied to the load via the control device, in a first operating mode for the device in which the supply of electrical power is carried out via and under the control of said first power control element (6);
a switching element (5) located between two of the terminals (2, 3) and configured to selectively place the device in the first operating mode and in a second operating mode in which the supply of electrical power does not pass via the first power control element (6);
an event detector (4) connected to one of the terminals (2) and configured to detect an event in a line connected to this terminal (2) and to produce an output signal indicating the event when it detects it.

2. Device according to claim 1, in which the terminals (1, 2, 3) consist of a first terminal (1), a second terminal (2) and a third terminal (3), the switching element (5) being connected between the second (2) and the third (3) terminals so that an electrical current can pass between the second (2) and third (3) terminals when the device is in the second operating mode but not when the device is in the first operating mode, and the first power control element (6) is connected between the first terminal (1) and the third terminal (3), so that an electrical current can pass between the first (1) and third (3) terminals under the control of the first power control element (6).

3. Device according to any of claims 1 and 2, **characterized in that** it includes a current detector (7) associated with one of the terminals, the current detector (7) being configured to generate a signal indicating the current level in this terminal.

4. Device according to claims 2 and 3, **characterized in that** the current detector (7) is associated with the third terminal (3).

5. Device according to any of the above claims, **characterized in that** it also includes a voltage detector (8) associated with one of the terminals and configured to generate a signal indicating the voltage level in this terminal.

6. Device according to claims 2 and 5, **characterized in that** the voltage detector (8) is associated with the first terminal (1).

7. Device according to any of claims 5 and 6, **characterized in that** the voltage detector (8) and the first power control element (6) are associated so that a specific variation in the voltage causes the first power control element (6) to pass to an open state in which power cannot reach the load.

8. Device according to any of the above claims, **characterized in that** the event detector (4) includes a resistor (41) connected to the terminal (2) to which the event detector is connected, and a circuit (42) connected to the resistor (41) and configured to generate the event signal in response to the detection of a current via the resistor (41).

9. Device according to any of the above claims, **characterized in that** it also includes a communications module (20) to communicate with a remote control unit (35), where the first power control element (6), the switching element (5) and the event detector (4) are connected to the communications module (20) so that the states of the first power control element (6) and the switching element (5) can be controlled from the remote control unit (35), via the communications module (20).

10. Device according to claim 9 and any of claims 3 and 4, **characterized in that** the current detector (7) is connected to the communications module (20).

11. Device according to claim 9 or 10 and any of claims 5-7, **characterized in that** the voltage detector (8) is connected to the communications module (20).

12. Device according to any of claims 9-11, **characterized in that** the communications module (20) is equipped with means for wireless communication (21) with the remote control unit (35).

13. A device according any of claims 1-8, **characterized in that** it includes an electronic control unit (30) configured so that it can change the state of the first power control element (6) between an open state in which power is allowed to pass and a closed state in which no power is allowed to pass, with the electronic control unit (30) configured so that in response to an output signal indicating the event from the event detector (4), it changes the state of the first power control element (6) so that if it is in the open state it switches to the closed state and if it is in the closed state, it switches to the open state.

14. A device according to claim 13, **characterized in that** the electronic control unit (30) is located in the device and connected to the first power control element (6), to the switching element (5) and to the event detector (4).

15. A system to control the power supplied to a load, **characterized in that** the system includes a device as in any of claims 1-12 and an electronic control unit (30), with the electronic control unit configured so that it can change the state of the first power control element (6) between the open state in which power is allowed to pass and a closed state in which no power is allowed to pass, with the electronic control unit (30) configured so that in response to an output signal indicating the event from the event detector (4), it changes the state of the first power control element (6) so that if it is in the open state it switches to the closed state and if it is in the closed state, it switches to the open state.

16. An installation to control the power supplied to a load, **characterized in that** it includes a device according to any of claims 1-14 or a system according to claim 15, and **in that** it further includes a second power control element (400) connected in a power line connected to the terminal (2) to which the event detector is connected (4).
